(19) Europäisches Patentamt
European Patent Office
Office européen des brevets

(11) **EP 0 833 449 A1**

(12) **EUROPÄISCHE PATENTANMELDUNG**

(43) Veröffentlichungstag:
01.04.1998 Patentblatt 1998/14

(51) Int. Cl.6: **H03K 17/082**

(21) Anmeldenummer: 97112181.9

(22) Anmeldetag: **16.07.1997**

(84) Benannte Vertragsstaaten:
**AT BE CH DE DK ES FI FR GB GR IE IT LI LU MC NL PT SE**

(30) Priorität: **30.09.1996 DE 19640433**

(71) Anmelder:
• **SIEMENS AKTIENGESELLSCHAFT**
**80333 München (DE)**
• **Harris Semiconductor GmbH**
**85540 Haar (DE)**

(72) Erfinder:
• **Göser, Gerhard**
**31170 Tournefeuille (DE)**
• **Elliot, Mark**
**93055 Regensburg (DE)**
• **Preslar, Donald**
**Ringoes, NJ (US)**

(74) Vertreter:
**Fuchs, Franz-Josef, Dr.-Ing.**
**Postfach 22 13 17**
**80503 München (DE)**

(54) **Leistungsendstufe zum Schalten induktiver Verbraucher**

(57) Eine Leistungsendstufe zum Schalten induktiver Verbraucher enthält eine Reihenschaltung aus dem Verbraucher L und einem Schalttransistor T. Zwischen Drain- und Gateanschluß des Schalttransistors ist eine Reihenschaltung einer Sperrdiode und einer Vielzahl von Zenerdioden angeordnet. Wenigstens einer Zenerdiode ist ein Kondensator, ein Widerstand oder eine Reihen- oder Parallelschaltung eines Kondensators und eines Widerstandes angeordnet, wodurch der scharfe Knick in der Drainspannung beim Einsetzen der Zenerung abgerundet wird.

FIG 2

**Beschreibung**

Die Erfindung betrifft eine Leistungsendstufe zum Schalten induktiver Verbraucher, beispielsweise von Kraftstoff-Einspritzventilen für Kraftfahrzeug-Brennkraftmaschinen, nach dem Oberbegriff von Anspruch 1.

Beim Schalten induktiver Verbraucher, insbesondere beim Abschalten, wird in sehr kurzer Zeit ein hoher Spannungshub durchlaufen Aus der EP 0 680 147 A2 ist eine Leistungsendstufe bekannt, bei der zum Schutz des Schalttransistors diese hohe Abschaltspannung durch Zenerdioden begrenzt wird; beim Einsetzen der Zenerung entsteht ein scharfer Knick im zeitlichen Spannungsverlauf, wodurch eine elektromagnetische Abstrahlung verursacht wird, welche die Umgebung, d. h., andere elektrische oder elektronische Systeme, in Kraftfahrzeugen, beispielsweise ein Autoradio, negativ beeinflussen kann

Zur Verringerung von Störstrahlung auch bei geschalteten Leistungsendstufen mit Zenerung wird bislang die allgemein bekannte Lösung angewandt, den zeitlichen Verlauf des hohen Spannungshubs beim Abschalten zu verlangsamen, was aber den gesamten Schaltvorgang verlangsamt, wodurch der Schalttransistor höherer Verlustleistung ausgesetzt wird und die Abschaltgeschwindigkeit verschlechtert wird.

Es ist Aufgabe der Erfindung, eine geschaltete Leistungsendstufe für induktive Verbraucher dahingehend weiterzubilden, daß beim Schalten entstehende Störstrahlung wesentlich verringert wird, ohne den Schaltvorgang zu verlangsamen und ohne die Verlustleistung im Schalttransistor zu erhöhen.

Diese Aufgabe wird erfindungsgemäß durch die Merkmale des Patentanspruchs gelöst.
Ein Ausführungsbeispiel nach der Erfindung ist im folgenden unter Bezugnahme auf die schematische Zeichnung näher erläutert. Es zeigen:

Figur 1    die Schaltung einer bekannten Leistungsendstufe,
Figur 2    die Schaltung einer erfindungsgemäßen Leistungsend stufe, und
Figur 3    ein Spannungsdiagramm zu beiden Schaltungen.

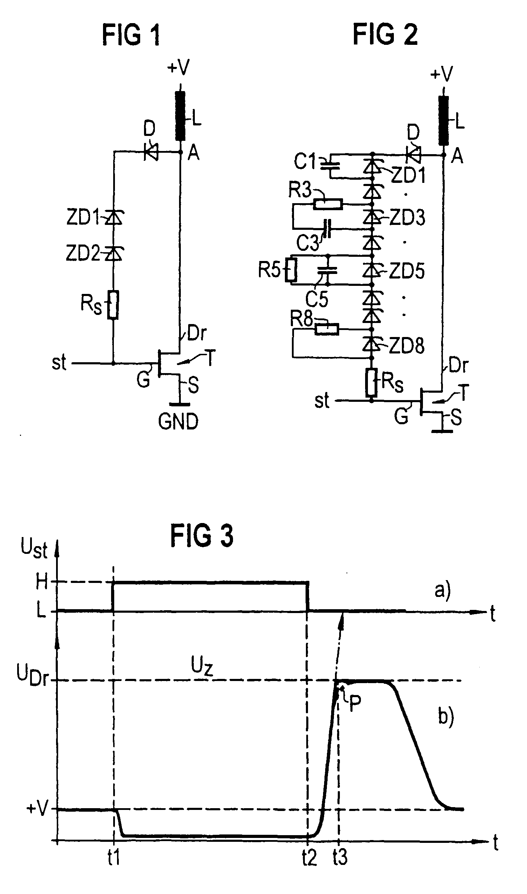

Figur 1 zeigt die Schaltung einer bekannten Leistungsendstufe zum Ansteuern eines induktiven Verbrauchers L am Beispiel eines Kraftstoff-Einspritzventils einer nicht dargestellten Kraftfahrzeug-Brennkraftmaschine.

Die Erregerspule L des Kraftstoff-Einspritzventils liegt mit einem Lowside-n-Kanal-Power-MOS-Transistor (Schalttransistor) T in Reihenschaltung zwischen dem Pluspol +V und dem Minuspol GND einer nicht dargestellten Betriebsspannungsquelle.

Zwischen dem Verbindungspunkt A zwischen der Erregerspule L und dem Drainanschluß Dr des Schalttransistors T und dem Steueranschluß (Gateanschluß G) des Schalttransistors T liegen eine zum Steueranschluß hin stromdurchlässige Sperrdiode D, zwei in Gegenrichtung dazu stromdurchlässige Zenerdioden ZD1 und ZD2 und ein Widerstand $R_S$ in Reihenschaltung.

Da Zenerdioden nicht für beliebig hohe Zenerspannungen erhältlich sind, kann in bekannter Weise anstelle einer Zenerdiode auch eine Reihenschaltung mehrerer Zenerdioden verwendet werden, deren Zenerspannungen sich addieren.

In Figur 3 zeigt das obere Signaldiagramm a den zeitlichen Verlauf eines Steuersignals $U_{st}$, welches dem Gateanschluß G des Schalttransistors T zugeführt wird, während das darunterliegende Signaldiagramm b den zeitlichen Verlauf der Drainspannung $U_{Dr}$ (der Spannung am Verbindungspunkt A) der Leistungsendstufe während eines Schaltvorgangs dargestellt.

Bei ausgeschaltetem Verbraucher L ($U_{st}$ = L) liegen seine beiden Anschlüsse und damit auch der Drainanschluß Dr des Schalttransistors T am Potential des Pluspols +V, beispielsweise +12V. Beim Erscheinen eines Steuersignals ($U_{st}$ = H) zum Zeitpunkt t1 wird der Schalttransistor T leitend, die Spannung am Drainanschluß Dr wird nahezu 0V und es fließt ein Strom vom Pluspol +V über den Verbraucher L und den Schalttransistor T zum Minuspol GND - der Verbraucher ist eingeschaltet, solange ein Steuersignal $U_{st}$ vorhanden ist.

Beim Abschalten des Verbrauchers L zum Zeitpunkt t2 wird der Schalttransistor T nichtleitend ($U_{st}$ = L); die Drainspannung $U_{Dr}$ am Punkt A steigt infolge der Induktivität des Verbrauchers L rasch an (strichpunktiert), und könnte Werte annehmen durch die der Schalttransistor T zerstört werden könnte. Das aber wird durch die Reihenschaltung aus Sperrdiode D, zwei Zenerdioden ZD1 und ZD2 und Widerstand Rs zwischen dem Verbindungspunkt A zwischen Verbraucher L und Schalttransistor T und dem Steueranschluß G des Schalttransistors T verhindert.

Die Sperrdiode D verhindert bei leitendem Schalttransistor T einen Stromfluß vom Gateanschluß G zum Drainanschluß Dr; die beiden in Reihe geschalteten Zenerdioden ZD1 und ZD2, deren Zenerspannung $U_z$ beispielsweise je 40V beträgt, brechen bei einer Zenerspannung $U_z$ = 8oV durch, sodaß, wenn die Drainspannung $U_{Dr}$ einen Wert von etwa 80V erreicht, vom Punkt A zum Gateanschluß G ein Strom fließt, der den Schalttransistor T im Zeitpunkt t3 öffnet und die Drainspannung $U_{Dr}$ damit auf den Wert der Zenerspannung $U_z$ begrenzt. Die Spulenenergie wird dadurch rasch abgebaut. Sobald der Spulenstrom abgebaut ist, sinkt die Drainspannung $U_{Dr}$ unter die Zenerspannung $U_z$ und der Schalttransistor T wird wieder nichtleitend (die Zenerdioden sperren wieder), so daß die Drainspannung rasch auf das Potential +V abfällt.

Der Anstieg der Drainspannung $U_{Dr}$ im Zeitpunkt t2 beim Abschalten des Verbrauchers L erfolgt stetig, bedingt durch das Schaltverhalten des Schalttransistors T; das Einsetzen der Zenerung (der Begrenzung der Drainspannung auf die Zenerspannung) im Zeitpunkt t3 hingegen erfolgt mit einem scharfen Knick, wodurch starke elektromagnetische Störstrahlung freigesetzt wird.

Figur 2 zeigt eine erfindungsgemäße Schaltung, die eine Minimierung dieser Störstrahlung ermöglicht. Diese Schaltung entspricht im wesentlichen der Schaltung nach Figur 1, wobei gleiche Schaltungselemente mit gleichen Bezugszeichen versehen sind, sodaß auf eine erneute Beschreibung verzichtet werden kann.

Der Unterschied dieser Schaltung zu der nach Figur 1 besteht darin, daß anstelle zweier Zenerdioden eine Vielzahl von in Reihe geschalteten Zenerdioden vorgesehen ist, wobei für eine Zenerspannung von 80V beispielsweise acht Zenerdioden ZD1 bis ZD8 mit einer Zenerspannung von je 10V vorgesehen sind.

Im Ausführungsbeispiel nach Figur 2 ist, um mehrere Möglichkeiten aufzuzeigen, zu Zenerdiode ZD1 ein Kondensator C1, zu Zenerdiode ZD3 eine Parallelschaltung aus einem Kondensator C3 und einem Widerstand R3, zu Zenerdiode ZD5 eine Reihenschaltung aus einem Kondensator C5 und einem Widerstand R5 und zu Zenerdiode ZD8 ein Widerstand R8 jeweils parallelgeschaltet.

Durch eine Parallelschaltung eines Kondensators , eines Widerstandes oder einer Reihen- oder Parallelschaltung eines Kondensators und eines Widerstandes zu einer Zenerdiode wird die an der Zenerdiode sich aufbauende Spannung je nach Dimensionierung der Bauelemente zeitlich geringfügig verzögert, so daß der Einsatz der Begrenzung der Drainspannung $U_{Dr}$ auf die Zenerspannung $U_z$ nicht mit einem scharfen Knick, sondern je nach Anzahl der auf diese Weise „verzögerten" Zenerdioden mit einem Polygonzug P, also, wie in Figur 3 zum Zeitpunkt t3 strichliert dargestellt, mehr abgerundet erfolgt. Dadurch wird eine wesentlich geringere elektromagnetische Störstrahlung freigesetzt als bei der Schaltung nach Figur 1. Der übrige Verlauf der Drainspannung $U_{Dr}$ entspricht dem bereits in Figur 3 eingezeichneten Verlauf.

Die Schaltungen nach den Figuren 1 und 2 sind mit n-Kanal-Feldeffekt-Transistoren T bestückt. Sie funktionieren genausogut mit p-Kanal-FET's oder mit anderen Transistoren (pnp-statt npn-Transistoren) mit an sich bekannter Umpolung der Spannung bzw. Vertauschung der Emitter- und Kollektoranschlüsse.

## Patentansprüche

1. Leistungsendstufe zum Schalten induktiver Verbraucher, mit einer zwischen den Polen (+V, GND) einer Spannungsquelle (V) angeordneten Reihenschaltung aus dem Verbraucher (L) und einem Schalttransistor (T),

mit einer Reihenschaltung aus einer Sperrdiode (D) und wenigstens einer Zenerdiode (ZD1 bis ZD8) zwischen dem Verbindungspunkt (A) zwischen Verbraucher (L) und Schalttransistor (T) und dem Steueranschluß (G) des Schalttransistors (T),

**dadurch gekennzeichnet,**

daß wenigstens einer der Zenerdioden (ZD1 bis ZD8) jeweils entweder ein Kondensator (C1), ein Widerstand (R8) oder eine Reihenschaltung (R3, C3) oder Parallelschaltung (R5, C5) aus einem Kondensator und einem Widerstand parallelgeschaltet ist.

# FIG 1

# FIG 2

# FIG 3

Europäisches
Patentamt

**EUROPÄISCHER RECHERCHENBERICHT**

Nummer der Anmeldung

EP 97 11 2181

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int.Cl.6) |
|---|---|---|---|
| X | PATENT ABSTRACTS OF JAPAN vol. 006, no. 215 (E-138), 28.Oktober 1982 & JP 57 118439 A (HITACHI SEISAKUSHO KK), 23.Juli 1982, * Abbildung * | 1 | H03K17/082 |
| A | EP 0 493 185 A (PEUGEOT ;CITROEN SA (FR)) * das ganze Dokument * | 1 | |
| A | PATENT ABSTRACTS OF JAPAN vol. 095, no. 007, 31.August 1995 & JP 07 106862 A (NEC CORP), 21.April 1995, * Zusammenfassung * | 1 | |
| A | US 5 111 353 A (KOTOWSKI JEFFREY P ET AL) * das ganze Dokument * | 1 | |
| A | DE 44 28 675 A (SIEMENS AG) * Abbildung 6 * | 1 | RECHERCHIERTE SACHGEBIETE (Int.Cl.6) |
| A | DE 28 11 149 A (BOSCH GMBH ROBERT) * das ganze Dokument * | 1 | H03K |

Der vorliegende Recherchenbericht wurde für alle Patentansprüche erstellt

| Recherchenort | Abschlußdatum der Recherche | Prüfer |
|---|---|---|
| DEN HAAG | 4.November 1997 | Jepsen, J |

KATEGORIE DER GENANNTEN DOKUMENTE

X : von besonderer Bedeutung allein betrachtet
Y : von besonderer Bedeutung in Verbindung mit einer
    anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder
    nach dem Anmeldedatum veröffentlicht worden ist
D : in der Anmeldung angeführtes Dokument
L : aus anderen Gründen angeführtes Dokument

& : Mitglied der gleichen Patentfamilie, übereinstimmendes
    Dokument

EPO FORM 1503 03.82 (P04C03)